# DEMANDE DE BREVET EUROPEEN

(11) **EP 2 295 849 A1**
(43) Date de publication de la demande: **16.03.2011**
(21) Numéro de dépôt: 10174734.3
(22) Date de dépôt: 31.08.2010
(51) Int. Cl.: F21S 8/10, F21V 19/00, F21Y 101/02, F21W 101/14

(54) **Feu pour véhicule automobile**

(30) Priorité: 09.09.2009 FR 0956145
(71) Demandeur: Peugeot Citroën Automobiles SA, 78140 Vélizy-Villacoublay (FR)
(72) Inventeur: Peron, Rodolphe, 95220 Herblay (FR); Moynier, Gilles, 72190 Sarge les Le Mans (FR)
(74) Mandataire: Vigand, Régis Louis Michel

(57) **Abrégé**

L'invention concerne un feu (11) pour véhicule automobile comprenant un réflecteur (12) dans lequel est monté un dispositif d'éclairage (10), **caractérisé en ce que** ledit dispositif d'éclairage est constitué par un substrat (1) plié formant une pyramide (7) ou un prisme ouvert dont au moins deux des faces latérales (5) sont munies de diodes électroluminescentes (9).

## Description

La présente invention concerne de manière générale un dispositif d'éclairage et/ou de signalisation pour véhicule automobile. Plus particulièrement, la présente invention concerne un feu avant ou arrière comprenant un dispositif d'éclairage à base de diodes électroluminescentes.

II est connu dans l'art antérieur, en particulier du document US 6250788, un phare 52 de véhicule automobile 51 comportant une surface fonctionnelle sur laquelle sont réparties des premières diodes luminescentes 53 d'une couleur uniforme destinées à rendre visible un premier état de fonctionnement du véhicule et des deuxièmes diodes luminescentes 55 supplémentaires de la même couleur pour rendre visible un deuxième état de fonctionnement du véhicule. En outre, des diodes luminescentes d'une autre couleur 54 et 56 sont prévues sur d'autres surfaces fonctionnelles. Un diffuseur optique 57 peut être prévu sur la périphérie du phare.

Un tel phare présente un double inconvénient. En effet, l'orientation des diodes luminescentes est limitée par la surface du véhicule sur laquelle le phare est apposé, fournissant un ensemble plan peu esthétique et entraînant une limitation des possibilités d'éclairage.

Il est également dans l'art antérieur, en particulier du document US 6520669, qui concerne un ensemble d'éclairage extérieur 60 pour véhicules, comprenant un substrat flexible 62 sur lequel est montée une pluralité de diodes électroluminescentes 64. Le substrat flexible est conçu pour être monté sur la surface extérieure du véhicule comme projecteur avant ou arrière et pour s'adapter aux lignes courbes de la surface extérieure 66. Des diodes électroluminescentes de couleurs différentes sont utilisées pour indiquer le freinage, le changement de direction ou pour éclairer la surface sur laquelle le véhicule évolue.

Un tel projecteur présente les mêmes inconvénients que le phare sus présenté. De la même manière, le positionnement et l'orientation des diodes électroluminescentes sont limités par la surface du véhicule sur laquelle le substrat flexible est apposé, entraînant les mêmes limitations en termes de possibilités d'éclairage.

Un but de la présente invention est de répondre aux différents inconvénients des documents de l'art antérieur mentionnés ci-dessus et en particulier, tout d'abord, de fournir un feu pour véhicule comprenant un dispositif d'éclairage à base de diodes électroluminescentes permettant d'obtenir une esthétique et des possibilités d'éclairage similaires à ceux obtenus avec des feux traditionnels.

Pour cela un premier aspect de l'invention concerne un feu pour véhicule automobile comprenant un réflecteur dans lequel est monté un dispositif d'éclairage, **caractérisé en ce que** ledit dispositif d'éclairage est constitué par un substrat plié de manière à former une pyramide ou un prisme ouvert dont au moins deux des faces latérales sont munies de diodes électroluminescentes. Un tel feu permet grâce à l'utilisation d'un réflecteur en association avec la forme en pyramide ou en prisme du substrat monté dans le réflecteur et sur lequel sont disposées les diodes électroluminescentes, d'obtenir toutes les orientations et effets lumineux souhaités. De cette manière, un tel feu pourra être utiliser tant à l'avant comme feux de route, de croisement ou de position, qu'à l'arrière du véhicule pour servir de feux de signalisation, tels que feu stop, de recul ou clignotant.

Selon un mode de réalisation avantageux, le substrat est découpé au niveau des arêtes latérales et prédécoupé au niveau des arêtes de la base de la forme prise par le substrat plié. De telles découpes et prédécoupes permettent de faciliter le pliage du substrat. Avantageusement, le substrat plié forme une pyramide tronquée, de préférence à base triangulaire ou rectangulaire. De telles formes tout en étant faciles à réaliser au niveau des découpes, disposent de trois, respectivement quatre, faces latérales assurant une grande variété de combinaisons dans l'implémentation des fonctions d'éclairage du feu.

Selon un autre mode de réalisation, la découpe au niveau d'au moins une arête latérale est élargie de sorte à former une encoche entre les deux faces latérales voisines situées de part et d'autre de la découpe. Avantageusement, toutes les découpes sont élargies formant une encoche entre chaque face latérale. La présence de telles encoches laisse libre la possibilité d'y insérer des parois réfléchissantes permettant de diviser le feu en plusieurs zones d'éclairage distinctes.

Selon une variante, une paroi réfléchissante est fixée dans au moins une des encoches, de préférence dans deux encoches pour plus de stabilité, séparant le réflecteur en deux zones d'éclairage. Une première face latérale située dans la première zone d'éclairage, est munie de diodes électroluminescentes assurant une première fonction d'éclairage, tandis qu'une deuxième face latérale située dans la deuxième zone d'éclairage, est munie de diodes électroluminescentes assurant une deuxième fonction d'éclairage.

Selon une autre variante, une deuxième paroi réfléchissante est fixée dans une autre encoche séparant le réflecteur en trois zones d'éclairage, une première face latérale munie de diodes électroluminescentes étant située dans la première zone d'éclairage pour assurer une fonction de feu stop, une deuxième face latérale munie de diodes électroluminescentes étant située dans la deuxième zone d'éclairage pour assurer une fonction de feu de marche arrière et une troisième face latérale munie de diodes électroluminescentes étant située dans la troisième zone d'éclairage pour assurer une fonction de clignotant.

Selon un autre mode de réalisation, une même extrémité de chacune des faces latérales est munie d'une patte de fixation venant se fixer dans une ouverture du réflecteur assurant le maintien du substrat. De préférence, le réflecteur est parabolique.

De préférence, le substrat est directement fixé sur le réflecteur. Ainsi, les intervalles de tolérance de positionnement sont réduits.

De préférence, le substrat est directement fixé sur le réflecteur par l'intermédiaire de pattes de fixation intégrées au substrat. Ainsi, aucun système intermédiaire entre le substrat et le réflecteur permettant leur fixation respective l'un par rapport à l'autre n'est nécessaire. Le nombre global de pièces dans le bloc optique de véhicule s'en trouve diminué. Les pattes de fixation sont préférentiellement des clips. Le montage en est rendu encore plus simple.

De préférence, l'alimentation électrique des diodes électroluminescentes passe par une ou plusieurs des pattes d'alimentation intégrées au substrat. Ainsi, aucun fil électrique ne se promène à l'intérieur de la pyramide.

De préférence, le réflecteur ne comprend pas d'ouverture centrale. Seules de petites échancrures pour recevoir les pattes de fixation sont à prévoir dans le réflecteur. Le réflecteur, surtout s'il est parabolique, peut rester entier.

Un deuxième aspect de la présente invention concerne un véhicule automobile équipé à l'arrière avec au moins un feu selon le premier aspect.

D'autres caractéristiques et avantages de la présente invention apparaîtront plus clairement à la lecture de la description détaillée qui suit de modes de réalisation de l'invention donnés à titre d'exemples nullement limitatifs et illustrés par le dessin annexé, dans lequel :
- La figure 1a représente le substrat en position déplié avec les découpes et prédécoupes apparentes ;
- La figure 1b représente une vue extérieure du substrat plié sous forme de pyramide tronquée avec base rectangulaire ;
- La figure 1c représente une vue intérieure du substrat plié sous forme de pyramide tronquée ;
- La figure 2 représente un dispositif d'éclairage selon un mode de réalisation de l'invention comprenant un substrat plié et muni de diodes électroluminescentes sur ses faces latérales ;
- La figure 3 représente un feu équipé d'un dispositif d'éclairage selon un mode de réalisation de l'invention ;
- La figure 4a représente une vue éclatée d'un feu équipé d'un dispositif d'éclairage selon un autre mode de réalisation de l'invention ;
- La figure 4b représente un feu selon la figure 4a en position montée ;
- La figure 4c représente une variante de réalisation du feu selon la figure 4b ;
- La figure 5 représente un phare selon un document de l'art antérieur ;
- La figure 6 représente un feu selon un autre document de l'art antérieur.

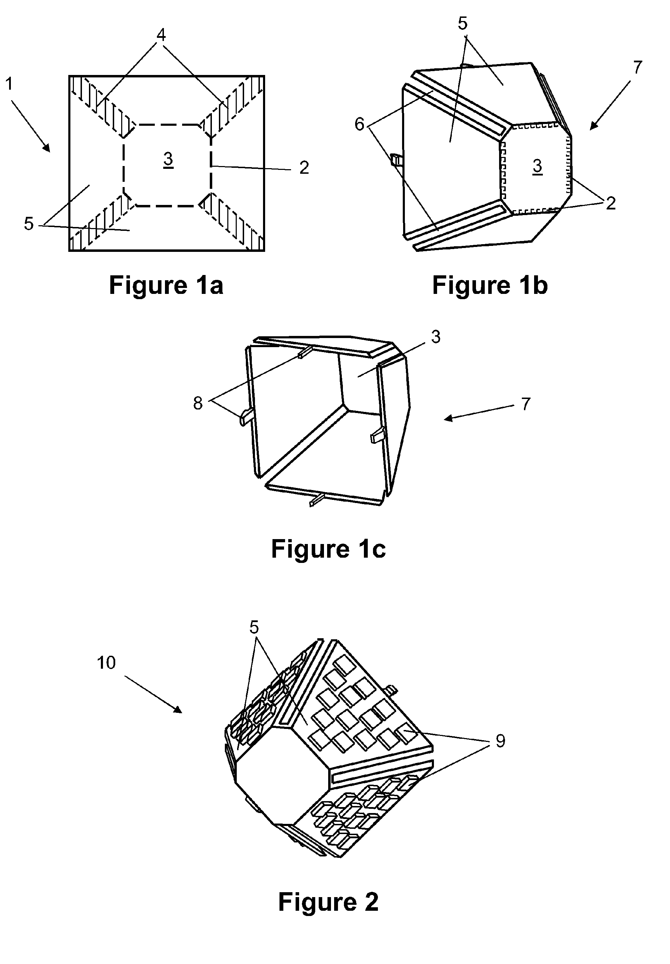

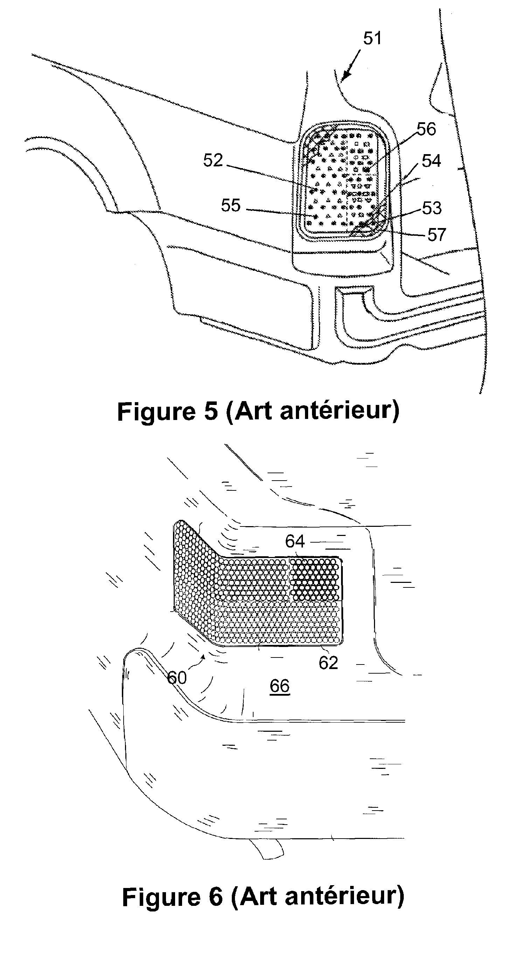

L'invention sera décrite ci-après uniquement à titre d'exemple non limitatif en relation avec les figures 1a à 4c, les figures 5 et 6 ayant déjà été décrites dans le cadre de la présentation de l'art antérieur.

La figure 1a représente un substrat 1 en position dépliée. Dans cet exemple, le substrat est de forme rectangulaire. On notera que ce substrat est de préférence une carte de circuit imprimé ou plaque PCB. Afin de pouvoir plier aisément la carte formant le substrat 1, il est prévu une prédécoupe 2 formant une base 3 sensiblement rectangulaire et des découpes 4 hachurées, disposées aux quatre coins du rectangle de base 3 et délimitant des faces latérales 5. On entend par prédécoupes, des marques faites dans le substrat pour faciliter son pliage le long de ces marques. Par ailleurs, on entend par découpe, la section du substrat de part en part permettant de désolidariser les deux parties situées de part et d'autre de cette découpe. Sur l'exemple représenté, les découpes 4 sont élargies de sorte à laisser un espace entre les deux faces latérales 5. Toutefois, on comprendra qu'il est également possible de réaliser des découpes linéaires ne laissant aucun espace entre deux faces latérales.

La figure 1b représente une vue extérieure du substrat plié sous forme d'une pyramide tronquée 7 avec base rectangulaire. Comme cela est visible sur cette figure, les prédécoupes 2 sont agencées au niveau des arêtes entre la base 3 et les faces latérales 5 de sorte à faciliter le pliage entre ces différentes faces. Les découpes réalisées entre les faces latérales sont élargies de sorte à former des encoches 6 entre chacune des faces latérales 5. On comprendra qu'il est également possible de réaliser des découpes et prédécoupes de sorte à obtenir une pyramide tronquée à base triangulaire ou encore un prisme à base triangulaire ou rectangulaire. Bien que d'autres formes de polyèdre soient également possible à réaliser, les formes susmentionnées présentent l'avantage de nécessiter qu'un petit nombre de découpes et de prédécoupes simples.

La figure 1c représente une vue intérieure du substrat 1 plié de la figure 1 b. La pyramide tronquée 7 ainsi réalisée est ouverte du côté opposé à la base 3. Les arêtes situées à l'extrémité des faces latérales, côté ouvert de la pyramide, sont munies d'élément de fixation 8 destinés à coopérer avec le réflecteur d'un feu (non visible sur cette figure) afin d'assurer le maintien de la pyramide dans le réflecteur. Ces éléments de fixation sont par exemple des éléments de clipsage ou des doigts.

La figure 2 représente un dispositif d'éclairage selon un mode de réalisation préféré de l'invention. Le dispositif d'éclairage 10 comprend un substrat plié en forme de pyramide tronquée et muni de diodes électroluminescentes 9 sur au moins deux de ses faces latérales 5 et, de préférence, sur chacune d'entre elles. Les diodes électroluminescentes agencées sur une face latérale peuvent être d'une couleur différente de celles agencées sur une autre face latérale. Les diodes sont de préférence soudées sur la face les supportant. Leur nombre peut varier en fonction de la taille de la fonction et de l'intensité lumineuse souhaitées.

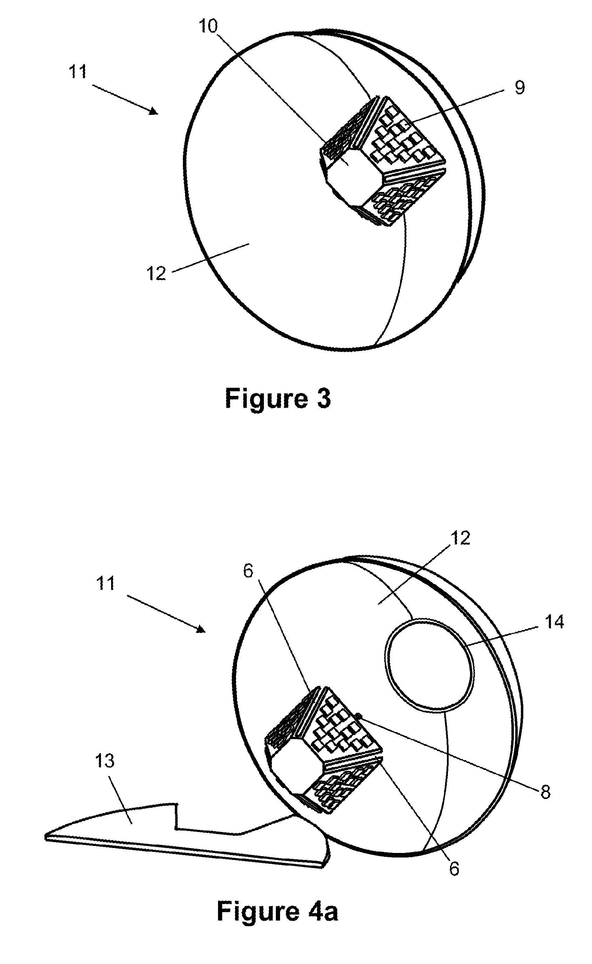

La figure 3 représente un feu 11 équipé d'un dispositif d'éclairage 10.
Le feu comprend un réflecteur 12, de préférence parabolique, à l'intérieur duquel est fixé la pyramide tronquée par l'intermédiaire des pattes de fixation (non visibles sur cette figure) venant se fixer au travers d'une ouverture pratiquée sur le réflecteur parabolique 12 selon un axe d'assemblage prédéfini. Les pattes de fixation peuvent être bouterolées à l'arrière du réflecteur pour assurer un bon maintien du dispositif d'éclairage. Ainsi, les diodes électroluminescentes sont agencées directement à l'intérieur du réflecteur parabolique à la manière des projecteurs à ampoule, ce qui permet d'obtenir des possibilités d'éclairage similaires. La connectique des diodes avec le dispositif de commande du dispositif d'éclairage est avantageusement agencée sur les face l'intérieure de la pyramide ce qui la rend invisible depuis l'extérieur du feu 11.

La figure 4a représente une vue éclatée d'un feu 11 équipé d'un dispositif d'éclairage 10 et d'une paroi réfléchissante 13. Le dispositif d'éclairage 10 en forme de pyramide vient se fixer sur le réflecteur parabolique 12 par l'intermédiaire des pattes de fixation 8 venant se clipser dans l'ouverture 14 pratiquée au fond du réflecteur 12. Dans cet exemple, une paroi réfléchissante 13 est prévue pour être calée dans des encoches 6 du dispositif d'éclairage.

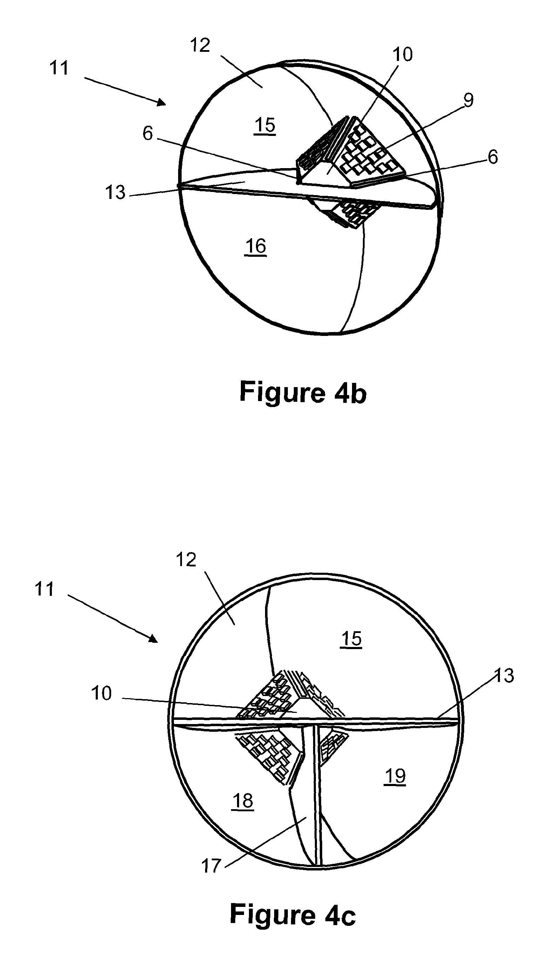

La figure 4b représente le feu 11 monté de la figure 4a. Le dispositif d'éclairage 10 est fixé sur le réflecteur parabolique 12 et la paroi réfléchissante 13 est calée dans au moins une et de préférence deux encoches 6 du dispositif d'éclairage. Dans cette position, la paroi réfléchissante divise le réflecteur en deux zones d'éclairage 15 et 16. Ainsi, les diodes électroluminescentes 9 situées dans la première zone d'éclairage 15 peuvent être allouée à une première fonction tandis que les diodes électroluminescentes situées dans la deuxième zone d'éclairage 16 peuvent être allouée à une deuxième fonction. Pour cela, les diodes électroluminescentes situées dans l'une et dans l'autre des deux zones d'éclairage peuvent être par exemple de couleurs différentes. Ainsi on obtient deux fonctions en utilisant qu'un seul dispositif d'éclairage. Par exemple, une première fonction pourra être en partie haute (zone d'éclairage 15) une fonction de feu stop obtenue au moyen de diodes de couleurs rouges et une deuxième fonction en partie basse (zone d'éclairage 16) une fonction clignotant obtenue au moyen de diodes de couleurs oranges.

La figure 4c représente une variante de réalisation du feu selon la figure 4b. Sur cette figure, le feu 11 est pourvu, outre le dispositif d'éclairage 10 fixé sur le réflecteur 12 et la paroi réfléchissante 13 séparant en deux la zone d'éclairage du réflecteur, une deuxième paroi réfléchissante 17 fixée dans une autre encoche 6 permettant de séparer en trois zones d'éclairage 15, 18 et 19 le réflecteur. Ces parois réfléchissantes sont issues du masque du feu.

Dans cet exemple, on pourra par exemple avoir en partie haute (zone d'éclairage 15) une première fonction feu stop obtenue au moyen de diodes de couleurs rouges, en partie basse à gauche (zone d'éclairage 18) une deuxième fonction clignotant obtenue au moyen de diodes de couleurs oranges et en partie basse à droite (zone d'éclairage 19) une troisième fonction recul obtenue au moyen de diodes de couleurs blanches.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées.

## Revendications

1. Feu (11) de véhicule automobile comprenant un réflecteur (12) dans lequel est monté un dispositif d'éclairage (10), **caractérisé en ce que** ledit dispositif d'éclairage est constitué par un substrat (1) plié formant une pyramide (7) ou un prisme ouvert dont au moins deux des faces latérales (5) sont munies de diodes électroluminescentes (9).

2. Feu (11) selon la revendication 1, **caractérisé en ce que** le substrat (1) est découpé au niveau des arêtes latérales (5) et prédécoupé au niveau des arêtes de la base (3) de la forme prise par le substrat plié.

3. Feu (11) selon la revendication 1 ou 2, **caractérisé en ce que** le substrat (1) plié forme une pyramide tronquée (7).

4. Feu (11) selon la revendication 3, **caractérisé en ce que** la découpe (4) au niveau d'au moins une arête latérale (5) est élargie de sorte à former une encoche (6) entre les deux faces latérales voisines situées de part et d'autre de la découpe.

5. Feu (11) selon la revendication 4, **caractérisé en ce que** toutes les découpes (4) sont élargies formant une encoche (6) entre chaque face latérale (5).

6. Feu (11) selon la revendication 4 ou 5, **caractérisé en ce qu'**une paroi réfléchissante (13) est fixée dans au moins une des encoches (6), séparant le réflecteur (12) en deux zones d'éclairage (15, 16), et **en ce qu'**une première, respectivement une deuxième, face latérale munie de diodes électroluminescentes est située dans la première, respectivement la deuxième, zone d'éclairage assurant une première, respectivement une deuxième, fonction d'éclairage.

7. Feu (11) selon la revendication 6, **caractérisé en ce qu'**une deuxième paroi réfléchissante (17) est fixée dans une autre encoche (6) séparant le réflecteur (12) en trois zones d'éclairage (15, 18, 19), une première face latérale munie de diodes électroluminescentes étant située dans la première zone d'éclairage pour assurer une fonction de feu stop, une deuxième face latérale munie de diodes électroluminescentes étant située dans la deuxième zone d'éclairage pour assurer une fonction de feu de marche arrière et une troisième face latérale munie de diodes électroluminescentes étant située dans la troisième zone d'éclairage pour assurer une fonction de clignotant.

8. Feu (11) selon l'une quelconque des revendications précédentes, **caractérisé en ce que** l'extrémité, côté ouvert, de chacune des faces latérales (5) est munie d'une patte de fixation (8) venant se fixer dans une ouverture (14) du réflecteur.

9. Feu (11) selon l'une quelconque des revendications précédentes, **caractérisé en ce que** le réflecteur (12) est parabolique.

10. Feu (11) selon l'une quelconque des revendications précédentes, **caractérisé en ce que** le substrat (1) est directement fixé sur le réflecteur (12).

11. Feu (11) selon la revendication 10, **caractérisé en ce que** le substrat (1) est directement fixé sur le réflecteur (12) par l'intermédiaire de pattes de fixation (8) intégrées au substrat (1).

12. Feu (11) selon la revendication 11, **caractérisé en ce que** l'alimentation électrique des diodes électroluminescentes (9) passe par une ou plusieurs des pattes d'alimentation (8) intégrées au substrat (1).

13. Feu (11) selon l'une quelconque des revendications précédentes, **caractérisé en ce que** le réflecteur (12) ne comprend pas d'ouverture centrale.

14. Véhicule automobile équipé à l'arrière avec au moins un feu (11) selon l'une quelconque des revendications précédentes.
